# DEMANDE DE BREVET EUROPEEN

(11) **EP 1 808 890 A1**
(43) Date de publication de la demande: **18.07.2007**
(21) Numéro de dépôt: 07290029.3
(22) Date de dépôt: 10.01.2007
(51) Int. Cl.: H01L 21/762

(54) **Procédé de réalisation d'une couche monocristalline sur une couche diélectrique**

(30) Priorité: 17.01.2006 FR 0600413
(71) Demandeur: STMicroelectronics ( Crolles 2) SAS, 38920 Crolles (FR)
(72) Inventeur: Kermarec, Olivier, 38610 Gieres (FR); Campidelli, Yves, 38000 Grenoble (FR)
(74) Mandataire: Zapalowicz, Francis

(57) **Abrégé**

Le procédé concerne la réalisation d'une couche d'un premier matériau monocristallin sur un deuxième matériau, ledit deuxième matériau étant situé entre au moins deux portions 3, 4 de surface d'un troisième matériau monocristallin 1, dans lequel :
a) on forme une couche monocristalline dudit premier matériau sur chacune desdites deux portions 3, 4 de surface du troisième matériau 1, puis
b) on fait croître par épitaxie la couche monocristalline du premier matériau formée sur chacune desdites deux portions 3, 4 de surface du troisième matériau 1, jusqu'au moins l'obtention d'un recouvrement par le premier matériau, du deuxième matériau 2 situé entre lesdites deux portions 3, 4 de surface du troisième matériau 1, et
c) on réalise un recuit.

## Description

La présente invention concerne une méthode de réalisation d'une couche semi-conductrice monocristalline sur une couche diélectrique, et plus particulièrement la réalisation localisée d'une couche semi-conductrice monocristalline sur une couche diélectrique.

Les plaquettes semi-conductrices sont le support des circuits intégrés actuels. Le choix, la qualité et les dimensions du matériau semi-conducteur de la plaquette conditionnent la réalisation et les performances des circuits intégrés qui seront fabriqués sur la plaquette. Initialement en silicium pur, les compositions des plaquettes ont évolué grâce à l'apparition de nouvelles technologies. Ainsi, un exemple d'évolution en matière de plaquettes semi-conductrices est la réalisation de plaquettes en silicium monocristallin sur isolant appelées Silicon On Insulator (SOI). Dans ces plaquettes, la couche de silicium utile à l'intégration des dispositifs est beaucoup plus fine qu'auparavant, de l'ordre de quelques dizaines de nanomètres. Une couche sous-jacente diélectrique, intercalée entre la couche de silicium utile et le substrat de silicium, permet, quant à elle, d'une part de donner une rigidité à l'ensemble mais également de jouer le rôle d'isolant électrique. Les performances des transistors réalisés dans ce type de plaquettes ont pu ainsi être augmentées.

Une autre évolution dans le domaine des plaquettes semi-conductrices est le remplacement du silicium par un matériau semi-conducteur présentant une résistivité électrique plus faible. Un exemple d'un tel matériau est le germanium. On a ainsi proposé des plaquettes en alliage silicium-germanium sur isolant, ainsi que des plaquettes en alliage silicium-germanium contraint sur isolant. Ces dernières présentent une résistivité encore plus faible due aux contraintes exercées sur la couche semi-conductrice. Des plaquettes de germanium sur isolant ont également pu être réalisées, notamment grâce à un procédé déjà utilisé pour réaliser des plaquettes de silicium sur isolant et décrit dans le document « Réalisation en première mondiale du substrats Germanium sur Isolant (GeOI) » accessible sur le site internet du Commissariat à l'Energie Atomique (www.cea.fr). Le principe de ce procédé est de fragiliser en profondeur, à l'aide d'ions implantés, un matériau en volume, puis d'induire une fracture le long du plan fragilisé pour créer une fine plaquette. Cependant ce procédé ne permet de réaliser que des plaquettes entières de germanium sur isolant. Or, le germanium est un matériau coûteux et moins abondant que le silicium. De plus, selon le type de dispositif (transistors à canal n ou p) ou de fonctions (électroniques ou optoélectroniques), la technologie la plus performante peut être celle du silicium ou celle du germanium. Ainsi, afin de combiner les avantages des deux technologies, il peut être intéressant d'intégrer, sur le même circuit intégré, les technologies silicium et germanium. On parle alors de co-intégration. La co-intégration peut ainsi nécessiter d'intégrer localement, sur un substrat de silicium, des zones de germanium sur isolant. Le procédé décrit précédemment n'est donc pas adapté aux cas où les technologies silicium et germanium doivent être utilisées ensemble dans les circuits intégrés.

L'invention vise à apporter une solution à ce problème. L'invention a notamment pour but de proposer un procédé de réalisation d'une couche d'un premier matériau monocristallin sur un deuxième matériau, ledit deuxième matériau étant situé entre au moins deux portions de surface d'un troisième matériau monocristallin. Selon le procédé :
a) on forme une couche monocristalline dudit premier matériau sur chacune desdites deux portions de surface du troisième matériau, puis
b) on fait croître par épitaxie la couche monocristalline du premier matériau formée sur chacune desdites deux portions de surface du troisième matériau, jusqu'au moins l'obtention d'un recouvrement par le premier matériau, du deuxième matériau situé entre lesdites deux portions de surface du troisième matériau, et
c) on réalise un recuit.

Les premier et troisième matériaux sont de préférence des matériaux semi-conducteurs comprenant du bore, du germanium, du silicium, de l'arsenic, du phosphore, de l'antimoine, du tellure, du polonium, de l'astate ou leurs mélanges.

Avantageusement, le premier matériau comprend du germanium. Le troisième matériau peut comprendre du silicium. Enfin, le deuxième matériau est diélectrique et comprend, de manière préférentielle, un oxyde du troisième matériau ou un nitrure du troisième matériau.

Ainsi l'invention remédie aux inconvénients présentés précédemment en permettant de réaliser, de manière localisée, une couche de germanium monocristalline sur une couche diélectrique. En effet, l'ensemble germanium sur isolant est réalisé entre les portions de surface du troisième matériau. Le choix de l'emplacement pour ces portions de surface permet donc de définir la zone sur laquelle on souhaite réaliser la couche germanium sur isolant.

Comme indiqué, le troisième matériau comprend préférentiellement du silicium. En particulier, le troisième matériau peut être la couche de silicium monocristalline de la plaquette. La plaquette peut être librement choisie entre une plaquette de silicium monocristallin pur ou une plaquette de silicium sur isolant. Dans ce dernier cas, il est donc possible de réaliser, à moindre coût, une plaquette alliant à la fois les avantages du silicium sur isolant et les avantages du germanium sur isolant.

De manière préférentielle, l'étape a) du procédé comprend un dépôt chimique en phase vapeur (RPCVD) suivi d'un recuit de recristallisation.

On considère ici en particulier le cas dans lequel le premier matériau est du germanium, le troisième du silicium et le deuxième de la silice. L'étape a) permet de réaliser une première couche monocristalline de germanium sur la portion de surface du silicium. Le dépôt RPCVD permet de réaliser d'abord une première couche de germanium partiellement cristalline. La couche comprend ainsi différents germes cristallisés selon des réseaux pouvant être différents. On réalise alors un recuit de recristallisation qui permet de rendre la couche monocristalline en recristallisant les différents germes selon un même réseau cristallin, de préférence en continuité avec le réseau du silicium monocristallin.

Préférentiellement, avant l'étape a), on forme une couche comprenant ledit deuxième matériau sur au moins une partie de la surface dudit troisième matériau monocristallin, puis on réalise au moins deux ouvertures dans ladite couche comprenant ledit deuxième matériau, de manière à former deux portions de surface dudit troisième matériau monocristallin.

Il est ainsi particulièrement aisé de réaliser à des endroits précis, la couche monocristalline de premier matériau sur le deuxième matériau. Il suffit pour cela de déposer, à l'endroit choisi, une couche de deuxième matériau, puis de réaliser, de part et d'autre, au moins une ouverture présentant une portion de surface du troisième matériau.

Préférentiellement, on réalise une étape supplémentaire de polissage mécano-chimique de la surface du premier matériau.

Préférentiellement, on réalise ensuite le dépôt d'une couche diélectrique encapsulant la couche du premier matériau, un deuxième recuit à une température supérieure au point de fusion du premier matériau, puis un retrait de la couche diélectrique encapsulante.

Cette étape permet d'améliorer encore la qualité de la couche finale de premier matériau.

L'invention permet donc, dans certains cas, d'intégrer dans les circuits intégrés réalisés sur une couche monocristalline de silicium, la technologie développée autour de germanium, tout en évitant une augmentation importante des coûts.

De plus, la technique proposée est beaucoup plus simple que la plupart des autres techniques qui reposent sur des enchaînements complexes de lithographies, gravures, polissages, avec une ou deux étapes dans des machines d'épitaxie. Ici, les étapes a), b) et c) peuvent être enchaînées dans un seul réacteur d'épitaxie. Seule l'étape d'aplanissement et d'amincissement du premier matériau nécessite un outil autre que le réacteur d'épitaxie.

L'invention permet en particulier de réaliser, au sein d'une même plaquette, soit des transistors sur substrat de germanium sur isolant avec des transistors sur substrat de silicium sur isolant, soit des transistors sur substrat de germanium sur isolant avec des transistors sur substrat de silicium.

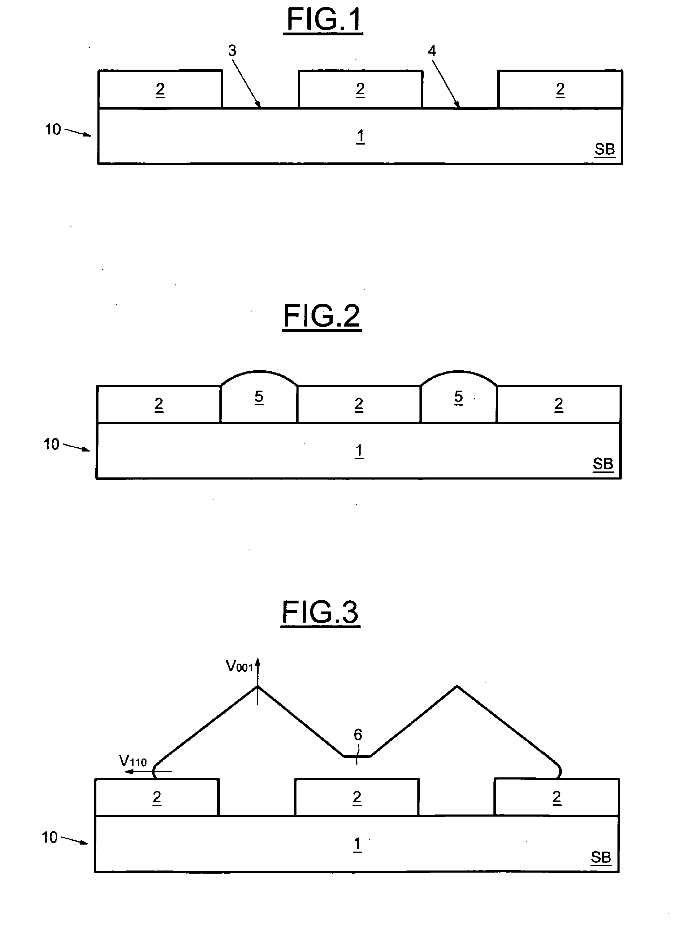

D'autres avantages et caractéristiques de l'invention apparaîtront à l'examen de la description détaillée d'un mode de mise en oeuvre et de réalisation, nullement limitatif, et des dessins annexés sur lesquels les figures 1 à 6 illustrent de manière schématique les principales étapes d'un mode de mise en oeuvre du procédé selon l'invention.

Sur la figure 1 est représentée une vue en coupe d'une portion de plaquette 10 d'un matériau monocristallin 1, sur lequel est réalisée une couche diélectrique 2. La couche diélectrique 2 présente deux ouvertures exposant chacune une portion 3, 4 de surface du matériau monocristallin 1. La plaquette de la figure 1 peut être réalisée, par exemple, par dépôt d'une couche diélectrique homogène 2 sur le matériau 1. Les ouvertures sont alors réalisées par gravure anisotrope. On pourra ainsi utiliser une résine insolée pour définir la position des ouvertures, puis graver la couche diélectrique 2 jusqu'à exposer la surface 3, 4 du matériau monocristallin 1. Une fois les ouvertures obtenues, les portions 3, 4 de surface du matériau 1 sont préparées selon des procédés de nettoyage avant épitaxie. Ainsi, dans le cas d'une plaquette de silicium monocristallin, on pourra réaliser ce nettoyage à l'aide d'un bain d'acide fluorhydrique (HF) suivi d'un rinçage à l'eau déionisée désoxygénée et d'un séchage à l'alcool isopropylique.

La figure 2 illustre l'étape de réalisation d'une couche monocristalline 5 du premier matériau sur chacune des portions 3, 4 de surface du matériau 1. Si les portions 3, 4 de surface sont distinctes, il y aura alors formation d'une couche monocristalline 5 sur la portion 3 et formation d'une couche monocristalline 5 sur la portion 4. Par contre, si la portion 3, 4 de surface entoure complètement une partie de la couche isolante 2, il y aura alors une seule couche monocristalline 5 entourant la partie de couche isolante 2.

Le dépôt de la couche monocristalline 5 de premier matériau s'effectue par exemple par un dépôt chimique en phase vapeur (RPCVD), basse température, dans un réacteur d'épitaxie « thermique ». Ce type de dépôt est connu en soi et on pourra se référer par exemple au brevet français FR 2 783 254. Le dépôt RPCVD peut être précédé par un nettoyage de la surface in-situ, à une température comprise entre 700°C et 1050°C, sous une pression de 10 à 80 Torr, et un débit de 10 à 30 slm (« standard liter per minute », c'est-à-dire litre par minute dans des conditions standard de pression (1 atm) et de température (0°C)) de H₂. Le dépôt du premier matériau, ici le germanium, s'effectue à une température comprise entre 300°C et 450°C, sous pression atmosphérique ou réduite (20 à 80 Torr), à un débit de GeH₄,H₂ compris entre 100 et 400 sccm (« standard centimeter cube per minute », c'est-à-dire centimètre cube par minute dans des conditions standard de pression (1 atm) et de température (0°C)) et à un débit de H₂ compris entre 10 et 60 slm. Les débits sont donnés à titre d'exemple lorsque GeH₄,H₂ correspond à du germane GeH₄ dilué à 10% dans de l'hydrogène H₂. Après le dépôt du germanium, on effectue un recuit de recristallisation à une température comprise entre 800°C et 900°C, pendant 1 minute, dans une atmosphère d'hydrogène, selon la méthode décrite dans le brevet français FR 2 783 254. Ce recuit, suivi ensuite d'une descente en température jusqu'à 450°C, peut être répété trois fois. Durant le dépôt, le germanium est naturellement sélectif par rapport à l'isolant. Le recuit qui suit le dépôt permet de former la couche monocristalline 5 sur les portions 3, 4 de surface.

La figure 3 illustre l'étape pendant laquelle on fait croître par épitaxie la couche monocristalline 5 du premier matériau formée précédemment. Dans l'exemple du germanium, on effectue tout d'abord une descente en température, dans une atmosphère d'hydrogène, jusqu'à une température comprise entre 450°C et 650°C. On réalise alors l'épitaxie du germanium sous 100 à 400 sccm de GeH₄,H₂ et sous 10 à 60 slm de H₂. Les débits sont donnés à titre d'exemple lorsque GeH₄,H₂ correspond à du germane GeH₄ dilué à 10% dans de l'hydrogène H₂. L'épitaxie est réalisée pendant le temps nécessaire pour permettre un recouvrement par le germanium 6 de la partie 2 du deuxième matériau-située entre les portions 3, 4 de surface, comme cela est représenté sur la figure 3. Cette jonction entre les deux couches monocristallines 5 crûes, permet un recouvrement complet du deuxième matériau 2 par le premier matériau 6 sur la distance séparant les deux portions 3 et 4. Cela est rendu possible par la croissance épitaxiale latérale du germanium. Les conditions de croissance épitaxiale sont donc adaptées de manière à avoir un rapport de croissance V₀₀₁/V₁₁₀ maximum. Au terme de l'étape, on obtient une couche 6 de premier matériau fortement facettée, en particulier au niveau des jonctions entre les deux couches monocristallines 5 voisines.

On réalise alors un recuit d'homogénéisation et d'aplanissement des surfaces des couches 6 de germanium. Le recuit est effectué à une température comprise entre 750°C et 900°C, dans une atmosphère d'hydrogène, et pendant une durée variant entre une minute et quelques heures suivant la taille des germes et la qualité finale du germanium désirée. Le recuit permet la cohésion des zones de germanium, en particulier au niveau des jonctions, et permet d'aplanir la surface. On voit alors qu'il est important que la jonction entre les couches monocristallines 5 ait lieu car sinon, la coalescence desdites couches 5 durant le recuit ne peut pas avoir lieu.

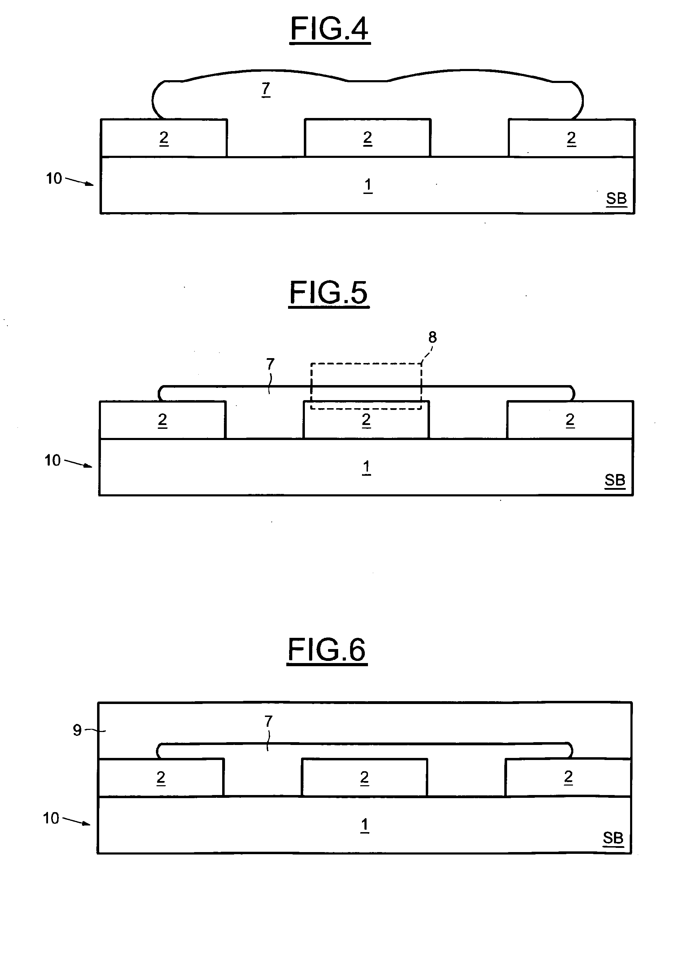

La figure 5 illustre une étape supplémentaire d'aplanissement de surface par un polissage mécano-chimique. Le polissage est effectué pour éliminer les ondulations rémanentes de la surface de la couche 7 de premier matériau et réduire l'épaisseur de la couche 7 si besoin. On obtient alors une zone 8 de germanium monocristallin sur isolant.

La figure 6 illustre une étape supplémentaire facultative. Dans cette étape, la couche 7 de premier matériau est recouverte par une couche diélectrique encapsulante 9, par exemple de la silice ou du nitrure de silicium. La couche encapsulante 9 peut également recouvrir, par exemple, une partie de la surface libre de la couche diélectrique 2. On effectue alors un recuit à une température supérieure au point de fusion du premier matériau, et dans une atmosphère d'hydrogène. Dans le cas du germanium, le recuit pourra être effectué par exemple à une température supérieure à 800°C.

Ainsi, le procédé propose une méthode de réalisation d'une couche d'un matériau tel que le germanium sur une couche diélectrique. En particulier, le procédé permet de réaliser une zone localisée dans laquelle on a une couche monocristalline de germanium sur isolant. Selon l'invention, la surface de la couche de l'isolant est sensiblement parallèle à la surface du troisième matériau sous-jacent. De plus, le troisième matériau sous-jacent est de préférence une couche de silicium monocristallin. Le procédé comprend un débordement latéral de l'épitaxie sur les zones oxydées.

En d'autres termes, l'invention se rapporte à un procédé de réalisation d'une couche de germanium monocristallin sur un isolant et sur deux portions de silicium monocristallin, le procédé comprenant une étape de formation d'une couche monocristalline de germanium sur les portions de silicium monocristallin, puis une étape de formation d'une couche de germanium monocristalline sur l'isolant et sur la couche monocristalline de germanium formée sur les portions de silicium monocristallin.

Grâce au procédé, il devient alors possible de réaliser, au sein d'une même plaquette, des transistors sur substrat de germanium sur isolant et des transistors sur substrat de silicium sur isolant ; ou bien des transistors sur substrat de germanium sur isolant et des transistors sur substrat de silicium pur. Le procédé permet également de limiter la quantité de germanium déposée et donc de limiter les coûts. Il est ainsi possible de réaliser des zones de quelques nanomètres carrés à quelques micromètres carrés présentant une surface de germanium monocristallin sur isolant.

## Revendications

1. Procédé de réalisation d'une couche (7) d'un premier matériau monocristallin sur un deuxième matériau, ledit deuxième matériau étant situé entre au moins deux portions (3, 4) de surface d'un troisième matériau monocristallin (1), **caractérisé par le fait que** :
a) on forme une couche (5) monocristalline dudit premier matériau sur chacune desdites deux portions (3, 4) de surface du troisième matériau (1), puis
b) on fait croître par épitaxie la couche (5) monocristalline du premier matériau formée sur chacune desdites deux portions (3, 4) de surface du troisième matériau (1), jusqu'au moins l'obtention d'un recouvrement par le premier matériau, du deuxième matériau situé entre lesdites deux portions (3, 4) de surface du troisième matériau (1), et
c) on réalise un recuit.

2. Procédé selon la revendication 1 dans lequel le premier matériau comprend du germanium.

3. Procédé selon l'une des revendications 1 ou 2 dans lequel le troisième matériau (1) comprend du silicium.

4. Procédé selon l'une des revendications précédentes dans lequel le deuxième matériau est diélectrique.

5. Procédé selon l'une des revendications précédentes dans lequel le deuxième matériau comprend un oxyde du troisième matériau ou un nitrure du troisième matériau.

6. Procédé selon l'une des revendications précédentes dans lequel l'étape a) comprend un dépôt chimique en phase vapeur (RPCVD) suivi d'un recuit de recristallisation.

7. Procédé selon l'une des revendications précédentes dans lequel, précédemment à l'étape a) :
- on forme une couche (2) comprenant ledit deuxième matériau sur au moins une partie de la surface dudit troisième matériau monocristallin (1), puis
- on réalise au moins deux ouvertures dans ladite couche (2) comprenant ledit deuxième matériau, de manière à former deux portion s (3, 4) de surface dudit troisième matériau monocristallin (1).

8. Procédé selon l'une des revendications précédentes dans lequel on réalise une étape supplémentaire de polissage mécan o-chimique de la surface du premier matériau.

9. Procédé selon l'une des revendications précédentes dans lequel on réalise ensuite:
- le dépôt d'une couche diélectrique (9) encapsulant la couche (7) du premier matériau,
- un deuxième recuit à une température supérieure au point de fusion du premier matériau, puis
- un retrait de la couche diélectrique (9) encapsulante.
